# EUROPEAN PATENT APPLICATION

(11) **EP 2 423 965 A1**
(43) Date of publication of application: **29.02.2012**
(21) Application number: 10008902.8
(22) Date of filing: 27.08.2010
(51) Int. Cl.: H01L 29/78, H01L 29/24

(54) **Electrochemically-gated transistor and a method for its manufacture**

(71) Applicant: Karlsruher Institut für Technologie, 76131 Karlsruhe (DE)
(72) Inventor: Hahn, Horst, Prof. Dr., 64342 Seeheim-Jugenheim (DE); Dasgupta, Subho, Dr., 76344 Eggenstein-Leopoldshafen (DE); Kruk, Robert, Dr., 76344 Eggenstein-Leopoldshafen (DE)
(74) Representative: Gärtner, Stephan

(57) **Abstract**

The present invention relates to an electrochemically-gated transistor on a substrate, comprising a source electrode (1), a drain electrode (2), a gate electrode (3), and a transistor channel (4) which is located between the source electrode (1) and the drain electrode (2), where a predominantly ionic conductor is provided as an electrolyte (5) which covers the transistor channel (4), which comprises nanoparticles of an inorganic semiconductor, completely and the gate electrode (3) only to a partial extent.

The present invention further relates to a method for manufacturing such an electrochemically-gated transistor. Such a device is a printable, inorganic nanoparticle-channel field-effect transistor which is obtained at processing temperatures below 250 °C and which works like an n-channel enhancement-mode MOSFET (NMOS).

## Description

The present invention relates to an electrochemically-gated transistor and a method for its manufacture.

Organic electronics still show several limitations, such as limited stability, low field-effect mobility and the fact that the vast majority of organic semiconductors are of p-type. One way to provide a negative charge-carrier metal-oxide-semiconductor (NMOS) device is to utilize inorganic materials. Solution-processed or printed inorganic transistors are manufactured either from a precursor or from a nanoparticle dispersion. The application of a precursor requires typically heating or annealing of the precursor after the printing procedure to obtain a crystalline film whereby the processing temperature is usually higher than 250 °C. On the other hand, as e. g. shown by K. Okamura, N. Mechau, D. Nikolova, and H. Hahn, Influence of interface roughness on the performance of nanoparticulate zinc oxide field-effect transistors, Appl. Phys. Lett. 93, (2008) 083105, the difficulty to establish a smooth interface between a nanoparticulate transistor channel and a dielectric impedes the technical realization of a field-effect transistor from a nanoparticle dispersion.

R. Misra, M. McCarthy, and A. F. Hebard, Electric field gating with ionic liquids, Appl. Phys. Lett. 90, (2007) 052905, have shown a change in resistance of a 4 nm thin indium oxide film where a surface charge has been applied by means of an ionic liquid.

A. S. Dhoot, J. D. Yuen, M. Heeney, I. McCulloch, D. Moses, and A. J. Heeger, Beyond the metal-insulator transition in polymer electrolyte gated polymer field-effect transistors, PNAS, 103 (2006) 11834, L. Herlogsson, Y. -Y. Noh, N. Zhao, X. Crispin, H. Sirringhaus, and M. Berggren, Downscaling of Organic Field-Effect Transistors with a Polyelectrolyte Gate Insulator, Adv. Mater., 20 (2008) 4708, M. J. Panzer, and C. D. Frisbie, High Carrier Density and Metallic Conductivity in Poly(3-hexylthiophene) Achieved by Electrostatic Charge Injection, Adv. Funct. Mater. 16 (2006) 1051, L. Herlogsson, X. Crispin, N. D. Robinson, M. Sandberg, O. -J. Hagel, G. Gustafsson, and M. Berggren, Low-Voltage Polymer Field-Effect Transistors Gated via a Proton Conductor, Adv. Mater., 19 (2007) 9, and L. Herlogsson, M. Cölle, S. Tierney, X. Crispin, and M. Berggren, Low-Voltage Ring Oscillators Based on Polyectrolyte-Gated Polymer Thin-Film Transistors, Adv. Mater. 22 (2010) 72, have demonstrated electrochemical gating of organic semiconductors.

In WO 2009/036856 A1 and in S. Dasgupta, S. Gottschalk, R. Kruk, and H. Hahn, A nanoparticulate indium tin oxide field-effect transistor with solid electrolyte gating, Nanotechnology 19 (2008) 435203, a device is shown where the conducting channel between the source electrode and the drain electrode was manufactured from spin-coated indium tin oxide (ITO) nanoparticles. Since ITO exhibits a metallic conducting behaviour, the transistor channel was highly conducting at zero gate bias, which resulted in a normally-on FET device (depletion-mode MOSFET). It may be noted here that a depletion-mode MOSFET (normally-on) device is technologically not so important like an enhancement-mode MOSFET (normally-off) device.

The main object of the present invention is therefore to provide an electrochemically-gated transistor and a method for manufacturing such a device, which overcome the limitations known from the state of the art.

In particular, it is an object of the present invention to provide a way to obtain a normally-off device (enhancement-mode MOSFET) with electrochemical gating.

Another object of the invention is to provide a method for manufacturing where an electrochemically-gated transistor can be processed at temperatures below 250 °C.

The solution of this problem is provided by an electrochemically-gated transistor according to claim 1 and a method of manufacturing an electrochemically-gated transistor according to claim 7. The dependent claims describe preferred features.

According to the present invention, an electrochemically-gated transistor is provided on a substrate which contains at least a source electrode, a drain electrode, a gate electrode and a nanoparticulate transistor channel which is located between the source electrode and the drain electrode. Hereby any durable and preferably flexible material is applicable as substrate, in particular a polymer or a material which at least partially contains a polymer.

A prerequisite for having a field effect and no chemical reaction in the electrochemically-gated transistor is that the material which composes the transistor channel needs to be chemically inert. The application of a chemically active nanomaterial would otherwise result in a change in the channel conductance due to a redox reaction. A redox reaction is capable of deteriorating the long-term reproducibility of the transistor behaviour and should therefore be avoided as much as possible.

This requirement is fulfilled by a transistor channel which at least partially consists of nanoparticles which are at least to a partial, preferably to a major extent, prepared from an inorganic semiconductor. In a preferred embodiment, the inorganic semiconductor contains oxides of indium In, gallium Ga, tin Sn, zinc Zn, titanium Ti, and or a mixture thereof, in particular indium oxide In₂O₃. In a specific embodiment, any of the mentioned oxides is doped, if applicable, with indium In, gallium Ga, tin Sn, zinc Zn, titanium Ti, antimony Sb, fluorine F and or a mixture thereof, as long as the doped material is semiconducting.

In addition, an electrolyte is provided which covers, on one hand, the transistor channel completely and, on the other hand, the gate electrode only partially. In a preferred embodiment, the electrolyte contains a liquid electrolyte or a solid poly-electrolyte at least to a partial extent.

It is mentioned that the present invention differs from the solution according to the WO 2009/036856 A1 in such a way that here an inorganic semiconductor with negligible conductivity at zero gate bias is gated (biased) by means of an electrolyte in order to provide a normally-off (enhancement-mode MOSFET) device which is technologically much more important. A normally-off (enhancement-mode MOSFET) device signifies off-state (negligible current) at zero gate bias whereas the device described in the WO 2009/036856 A1 was a normally-on device, i.e. it comprises a highly conducting channel at zero gate bias, so that a negative gate voltage was necessary to bring it to the off-state.

The present transistor device essentially contains two plate capacitors, one at each electrode-electrolyte interface, i.e. one at the transistor channel and one at the gate electrode. Ideally, no electron transfer exists across these interfaces, i.e. negligible chemical adsorption of ions of the electrolyte at the electrode surface. The printed inorganic semiconductor nanoparticles bridge the gap between the source electrode and the drain electrode. The electrolyte fully covers the transistor channel and partially the gate. Therefore, the first capacitor is located on the transistor channel side whereas the second capacitor is located on the gate side when a potential is applied. A part of the gate electrode is left uncovered by the electrolyte in order to be used as electrical contact.

Another aspect of the present invention is directed to the manufacturing an electrochemically-gated transistor with a source electrode, a drain electrode, a gate electrode, and a transistor channel which is located between the source electrode and the drain electrode.

First, a substrate is provided on which a source electrode, a drain electrode, and a gate electrode are located. Any durable and preferably flexible material is applicable as a substrate, particularly a polymer or a material which at least partially contains a polymer.

Then, a nanodispersion is prepared which at least contains nanoparticles of an inorganic semiconductor and, preferably, a stabilizer for a long-term stability of the nanodispersion. In a preferred embodiment, an in-organic semiconductor is chosen which comprises an oxide of indium In, gallium Ga, tin Sn, zinc Zn, titanium Ti or a mixture thereof, particularly indium oxide In₂O₃- In a specific embodiment, an oxide is chosen which is doped, if applicable, with indium In, gallium Ga, tin Sn, zinc Zn, titanium Ti, antimony Sb, fluorine F and or a mixture thereof, as long as the doped material is semiconducting.

In order to achieve a smooth interface between the nanoparticles and the electrolyte and to obtain a sufficient electric contact among the nanoparticles, it is necessary to be able to remove the stabilizer, if applied, at least partially prior to the addition of the electrolyte. Therefore, it is preferable to employ a low boiling-point surfactant. In a preferred embodiment, a stabilizer is chosen among weak organic bases or acids, in particular amines or thiols which exhibit a boiling-point below 250 °C, preferably below 200 °C, in particular below 180 °C, particularly piperazine or ethanolamine.

Thereafter, an amount of said nanodispersion is printed onto the substrate in a region which is located between the source electrode and the drain electrode in such a way that it bridges the gap between the source electrode and the drain electrode whereby the nanoparticulate transistor channel itself is formed. In a specific embodiment said region is heated to a temperature which is sufficient to remove the stabilizer at least partially. Preferably, the substrate is heated to a temperature below 250 °C, preferably below 200 °C, in particular below 180 °C, in order to remove the stabilizer.

Finally, an electrolyte is printed on top of the gate electrode and the transistor channel in such a way that it covers the transistor channel completely and the gate electrode only partially. In a preferred embodiment, a predominantly ionic conductor, which either is a liquid electrolyte or a solid polyelectrolyte, is chosen as the electrolyte. Such a liquid electrolyte penetrates all the pores of a printed nanoparticulate transistor channel and applies large local electric fields.

The specific advantage of the present invention is that a printable, inorganic nanoparticle-channel FET device is obtained at processing temperatures below 250 °C, preferably below 200 °C, in particular below 180 °C, which works as an n-channel enhancement-mode MOSFET (NMOS).

The present invention will be more apparent from the following description of non-limiting specific embodiments with reference to the drawings.
**Fig. 1** shows dynamic light scattering (DLS) data exhibiting the agglomerate size and the size distribution for indium oxide In₂O₃ nanoparticles with a primary particle size of 6 nm with the weak organic bases **(a)** Ethanolamine and **(b)** Piperazine as stabilizer. Two separate graphs were taken before and after centrifugation.
**Fig. 2** exhibits DLS data showing agglomerate size and size distribution for tin oxide SnO₂ nanoparticles with a primary particle size of 20 nm with the weak organic bases **(a)** Ethanolamine and **(b)** Piperazine as stabilizer. Two separate graphs were taken before and after centrifugation.
**Fig. 3** gives a schematic representation of a printed electrochemically-gated transistor after an In₂O₃ nanoparticle-based ink (nanoink) has been printed on a patterned passive structure, followed by the printing of the electrolyte. The electrolyte covers the transistor channel with the printed nanoparticles completely and the gate electrode only partially.
**Fig. 4** displays the gate voltage vs. the drain current with a drain voltage V_{D} = 100 mV of an ethanolamine-stabilized In₂O₃ nanoparticulate transistor channel FET, showing an enhancement-mode MOSFET-like behaviour with a positive threshold voltage.
**Fig. 5** exhibits the drain current vs. the drain voltage of an ethanolamine-stabilized In₂O₃ nanoparticulate transistor channel FET.
Fig. 6 shows the voltage inversion of a single-transistor inverter with a printed In₂O₃ transistor and a printed In₂O₃ resistor (load).

### Preparation of the nanodispersion

In a first step, 1 g of oxide nanoparticles was added to 10 ml of de-ionized water. Then, 1 wt.% of ethanolamine or piperazine was added as stabilizer, and finally yttria-stabilized zirconia pearls/beads were added as a milling material, particularly to break big agglomerates.

Then, this mixture was loaded in a laboratory mixer/dissolver and spun with 9000 rpm for 90 mins. Thereafter, the mixture was unloaded and filtered with a 5 µm hydrophilic filter to separate the grinding balls/beads. Then, the dispersion was centrifuged for 5 mins with a rotation speed of 5000 rpm. Since the centrifugation creates a concentration gradient along the height of the sample column with the bigger agglomerates at lower height, the top layer was carefully separated leaving 5-6 mm dispersion at the bottom and then filtered with a nanometer-sized (such as 200 nm or 450 nm) hydrophilic filter. After filtration the dispersion was ready as a nanoink and could be printed, e.g. with an ink-jet printer.

### Dynamic light scattering measurements

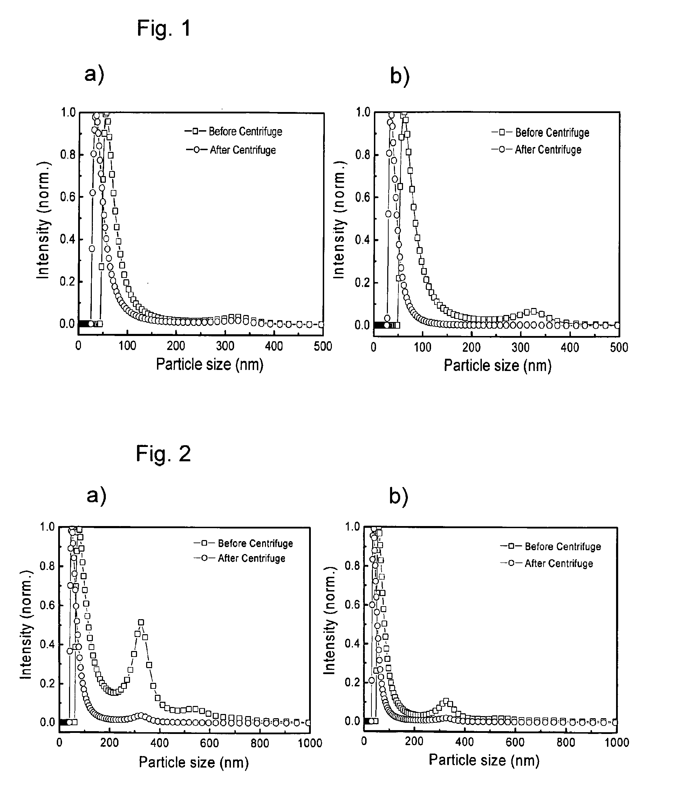

Dynamic light scattering measurements (DLS) measurements were performed before and after centrifugation for all investigated oxide nanopowders. **Fig. 1 and Fig. 2** shows the DLS results for indium oxide (In₂O₃, primary particle size = 6 nm) and for tin oxide (SnO₂, primary particle size = 20 nm) with the weak organic base Ethanolamine in **(a)** and the weak organic base Ethanolamine Piperazine in (b) as stabilizer. In each diagram two separate graphs which were taken before and after centrifugation are presented.

From **Fig. 1 and Fig.2** it can be concluded that the agglomerate size in the intermediate and in the final nanoink depends on the primary particle size. Further, piperazine-stabilized nanoink possesses a smaller agglomerate size than the ethanolamine-stabilized nanoink. However, it was found that the ethanolamine-stabilized dispersion stayed both stable and printable for a longer time than the piperazine-stabilized nanoink.

### Printing of the nanoink and the electrolyte

A poly(ethylenenaphthalate) PEN substrate was coated with 120 nm of sputtered indium tin oxide ITO and then structured with electron beam lithography. A line with a width of 10 µm was etched away, thus determining the length of the transistor channel. In addition, a third electrode which was intended to work as the gate electrode was prepared from sputtered ITO. The transistor prepared by this way is an in-plane transistor. It is noted that the electrode structure can also be printed using inks which are based on metallic conducting particles.

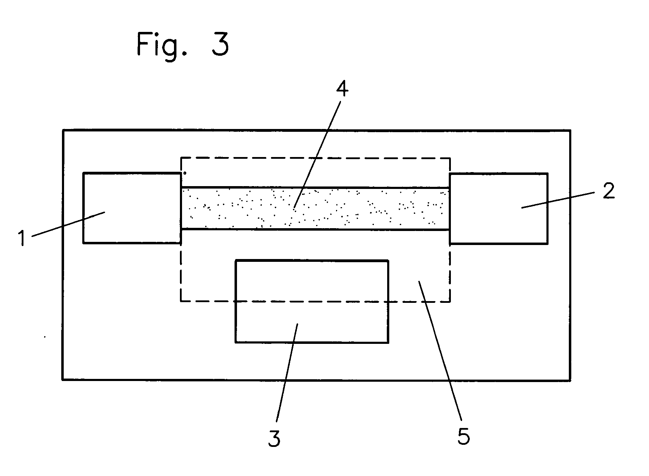

After printing an amount of the In₂O₃ nanoink, the substrate was heated to 180 °C to remove the stabilizers. Thereafter, a solid polyelectrolyte was printed in such a way that it completely covered the transistor channel and only partially covered the gate electrode as shown in Fig. 3. Here, a mixture of poly(vinylalcohol) PVA, potassium fluoride KF and de-ionized water H₂O was employed as electrolyte.

Fig. 3 gives a schematic representation of a printed electrochemically-gated transistor. In this example, an In₂O₃ nanoparticle ink was printed on a patterned passive structure, which comprises a source electrode 1, a drain electrode 2, and a gate electrode 3. It is noted that although the passive structures have been manufactured here by sputtered ITO, it is generally preferable to provide an all-printed device. On top of the passive structures the electrolyte **5** was printed. The electrolyte **5** covers the transistor channel **4** which contains the printed nanoparticles completely and the gate electrode **3** only partially.

### Transistor characteristics

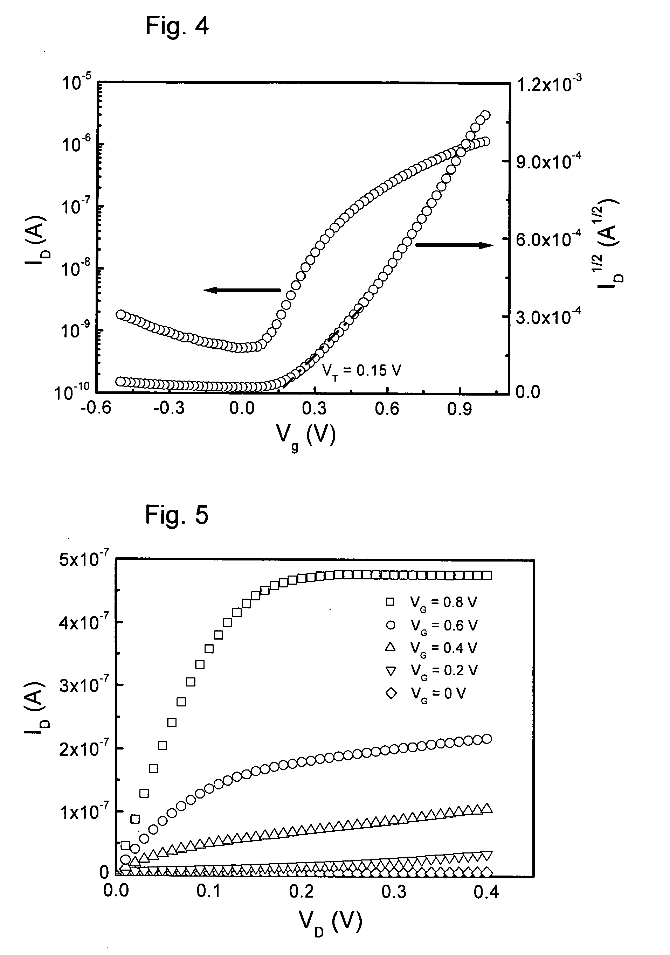

Transistor characteristics of an electrochemically-gated inorganic nanoparticulate transistor device are shown in **Fig. 4-6****.**

**Fig. 4** displays the standard gate-sweep of a transistor showing more than three orders of magnitude change in channel conductance. The positive threshold voltage and the negligible drain-source current at zero gate voltage indicate that it is a normally-off device (Enhancement-mode MOSFET). The drain-current-drain voltage characteristics of the same device are shown in **Fig. 5****.**

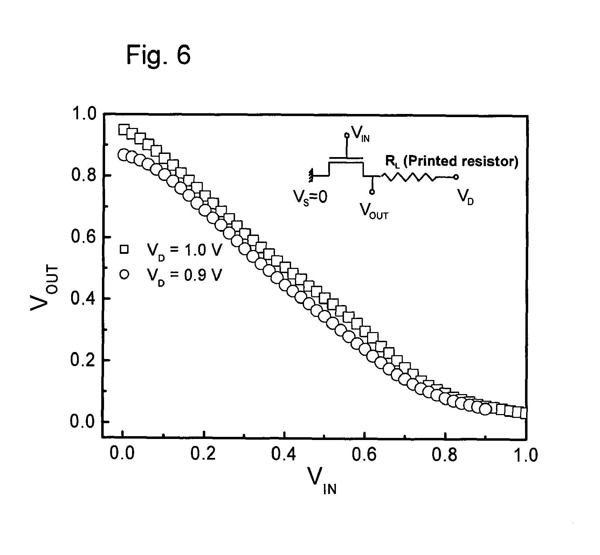

**Fig. 6** demonstrates the functionality of a single transistor NOT gate (inverter) where both the transistor-channel and the resistor (load) consist of printed In₂O₃ nanoparticles. In **Fig. 6** a drain voltage of 1 V has been applied, and the output voltage changes from near 1 V to nearly 0 V when the input voltage, which is the gate voltage of the transistor, is altered from 0 V to 1 V, respectively.

## Claims

1. Electrochemically-gated transistor on a substrate, comprising a source electrode (1), a drain electrode (2), a gate electrode (3), and a transistor channel (4) which is located between the source electrode (1) and the drain electrode (2), **characterized in that** a predominantly ionic conductor constitutes an electrolyte (5) which covers the transistor channel (4), which comprises nanoparticles of an inorganic semiconductor, completely and the gate electrode (3) only to a partial extent.

2. Electrochemically-gated transistor according to claim 1, **characterized in that** the inorganic semiconductor comprises an oxide of In, Ga, Sn, Zn, Ti or a mixture thereof.

3. Electrochemically-gated transistor according to claim 2, **characterized in that** the oxides are doped, if applicable, with In, Ga, Sn, Zn, Ti, Sb, F, or a mixture thereof, as long as the doped oxide is semiconducting.

4. Electrochemically-gated transistor according to claim 2 or 3, **characterized in that** the inorganic semiconductor comprises In₂O₃.

5. Electrochemically-gated transistor according to one of the claims 1 to 4, **characterized in that** the electrolyte (5) comprises a liquid electrolyte or a solid poly-electrolyte.

6. Electrochemically-gated transistor according to one of the claims 1 to 5, **characterized in that** the substrate contains a polymer at least to a partial extent.

7. Method of manufacturing an electrochemically-gated transistor with a source electrode (1), a drain electrode (2), a gate electrode (3), and a transistor channel (4) which is located between the source electrode (1) and the drain electrode (2), according to one of the claims 1 to 6, such method having **the following steps:**
- providing a substrate on which a source electrode (1), a drain electrode (2), and a gate electrode (3) are located, and
- providing a nanodispersion and printing an amount thereof onto the substrate in a region between the source electrode (1) and the drain electrode (2) in such a way that it bridges the gap between the source electrode (1) and the drain electrode (2), thereby forming a transistor channel (4),
- printing an electrolyte (5) on top of the gate electrode (3) and the transistor channel (4),
**characterized in that**
the nanodispersion comprises nanoparticles of an inorganic semiconductor and the electrolyte (5) is printed in such a way that it covers the transistor channel (4) completely and the gate electrode (3) only to a partial extent.

8. Method according to claim 7, **characterized in that** the inorganic semiconductor is chosen among oxides of In, Ga, Sn, Zn, Ti and mixtures thereof.

9. Method according to claim 8, **characterized in that** the inorganic semiconductor is chosen among oxides which are doped, if applicable, with In, Ga, Sn, Zn, Ti, Sb, F, and mixtures thereof, as long as the doped oxide is semiconducting.

10. Method according to claim 8 or 9, **characterized in that** In₂O₃ is chosen as the inorganic semiconductor.

11. Method according to one of the claims 7 to 10, **characterized in that** the nanodispersion which is provided further comprises a stabilizer.

12. Method according to claim 11, **characterized in that** the stabilizer is removed at least partially from the nanodispersion prior to the printing of the electrode (5).

13. Method according to claim 11 or 12, **characterized in that** the stabilizer is chosen among weak organic bases or acids, in particular amines or thiols which exhibit a boiling-point below 250 °C.

14. Method according to claim 13, **characterized in that** the stabilizer is chosen among ethanolamine or piperazine.

15. Method according to one of the claims 7 to 14, **characterized in that** a polymer or a material which at least partially contains a polymer is chosen as the substrate.
